**Europäisches Patentamt**

**European Patent Office**

**Office européen des brevets**

(19)

(11) Veröffentlichungsnummer: **0 025 582**
**B1**

# (12) EUROPÄISCHE PATENTSCHRIFT

(45) Veröffentlichungstag der Patentschrift:
**06.04.83**

(21) Anmeldenummer: **80105391.9**

(22) Anmeldetag: **09.09.80**

(51) Int. Cl.³: **H 04 M 1/60**

(54) **Mittels einer rastfreien Taste betätigbare Anordnung zum Ein- und Ausschalten und zur Lautstärkeeinstellung für einen Verstärker enthaltende fernmeldetechnische Geräte.**

(30) Priorität: **18.09.79 DE 2937638**

(43) Veröffentlichungstag der Anmeldung:
**25.03.81 Patentblatt 81/12**

(45) Bekanntmachung des Hinweises auf die Patenterteilung:
**06.04.83 Patentblatt 83/14**

(84) Benannte Vertragsstaaten:
**FR GB IT NL**

(56) Entgegenhaltungen:
**DE-A-1 816 146**
**DE-A-2 747 733**
**US-A-3 881 069**
**ELECTRONIC ENGINEERING, Band 50, Nr. 604, April 1978, London, GB P. ROTAMAKI «Speech amplifier shuts down automatically», Seite 33.**

(73) Patentinhaber: **KRONE GmbH, Goerzallee 311, D-1000 Berlin 37 (DE)**

(72) Erfinder: **Hornburg, Klaus, Reichweindamm 28, D-1000 Berlin 13 (DE)**

(74) Vertreter: **Patentanwälte Beetz sen. - Beetz jun. Timpe - Siegfried - Schmitt-Fumian, Steinsdorfstrasse 10, D-8000 München 22 (DE)**

Mittels einer rastfreien Taste betätigbare Anordnung zum Ein- und Ausschalten und zur Lautstärkeeinstellung für einen Verstärker enthaltende fernmeldetechnische Geräte

Die Erfindung betrifft eine mittels einer rastfreien Taste betätigbare Anordnung zum Ein- und Ausschalten und zur Lautstärkeeinstellung für einen Verstärker enthaltende fernmeldetechnische Geräte wie Freisprech- oder Lauthöreinrichtungen mit einer nach Schleifenstromunterbrechung wirksam werdende Abschaltautomatik für die Stromversorgung des Verstärkers.

Eine derartige Anordnung ist in Electronic Engineering, Band 50, Nr. 604, April 1978, Seite 33 beschrieben. Bei dieser bekannten Anordnung dient die Taste jedoch allein zum Ein- und Ausschalten, während für die Lautstärkeeinstellung ein regelbarer Widerstand vorgesehen ist. Auch in weiteren bekannten Anordnungen, wie sie in DE-A-2 747 733 oder in DE-A-1 816 146 beschrieben sind, bedarf es für die Lautstärkeeinstellung der Verwendung zweier getrennter Bedienungselemente, wobei in diesem Falle zwei Tasten vorgesehen sind.

Der Erfindung liegt daher die Aufgabe zugrunde, eine Anordnung der eingangs erwähnten Art zu schaffen, die hinsichtlich ihrer Bedienung vereinfacht ist und insbesondere keiner komplizierten Schaltmechanik bedarf.

Die gestellte Aufgabe wird gemäss der Erfindung gelöst durch eine Anordnung, wie sie im Patentanspruch 1 gekennzeichnet ist. Vorteilhafte Weiterbildungen der Erfindung ergeben sich aus den Unteransprüchen.

In der Zeichnung ist ein Ausführungsbeispiel für die Erfindung dargestellt; es zeigen:

Fig. 1 ein Blockschaltbild für eine Anordnung gemäss der Erfindung,

Fig. 2 ein Beispiel für eine schaltungsmässige Ausführung.

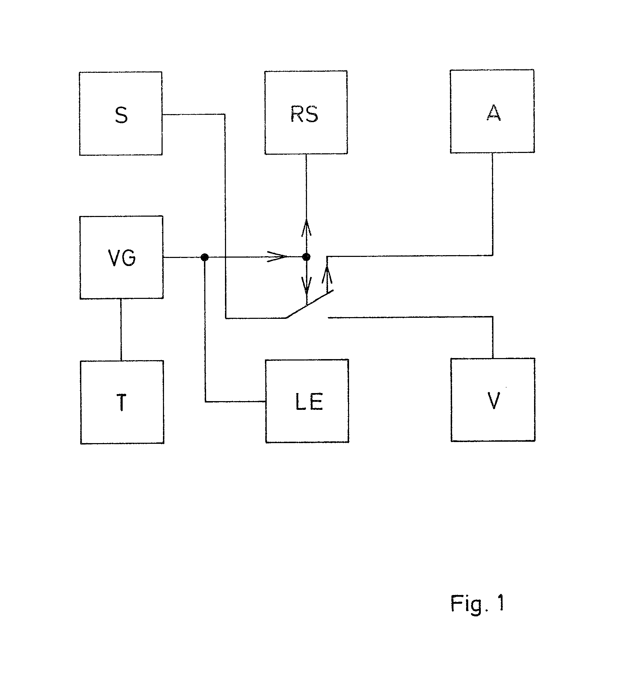

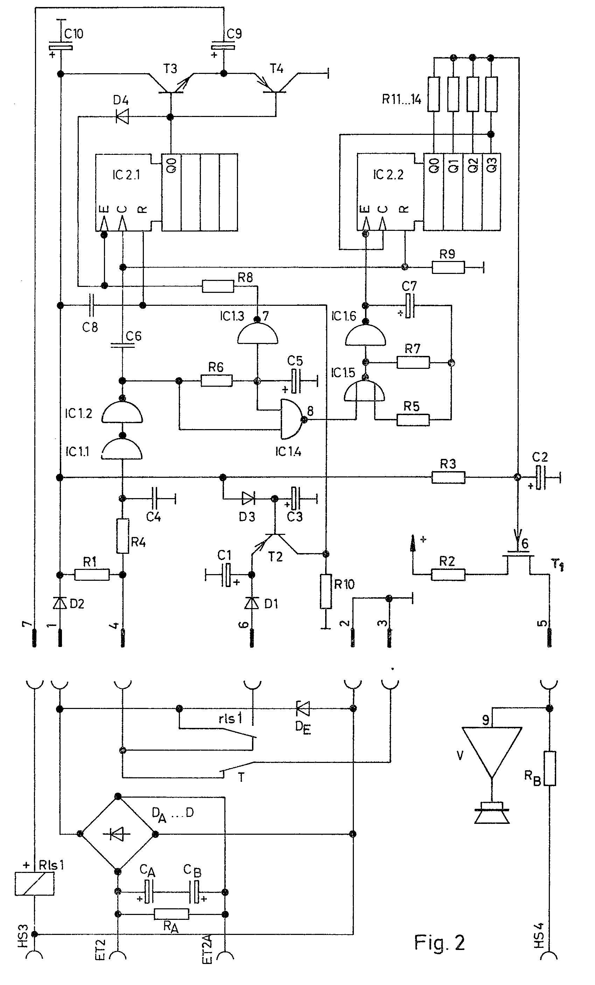

Wie die Figuren 1 und 2, insbesondere Fig. 2, zeigen, ist in einem ersten Ausführungsbeispiel die Relaissteuerung RS aus einem Binärzähler IC2.1, an dessen Ausgang Q0 die Transistoren T3 und T4 in einer Gegentaktschaltung zur Stromverstärkung, der Kondensator C9, das bipolare Relais Rls1 und die Diode D4, die mit Enable-Eingang E verbunden ist, und an dessen Rücksetzeingang R der Kondensator C8 und der Widerstand R10 und an dessen Takteingang C der Kondensator C6 und die Inverter IC1.1 und IC1.2 liegen, aufgebaut.

Beim Freigeben der Stromversorgung S durch kurze Betätigung der rastfreien Taste T wird der Kondensator C10 auf die von der Z-Spannung der Zenerdiode DE abhängige Spannung aufgeladen.

Der Kondensator C8 ist niederohmig und setzt den Binärzähler IC2.1 in Nullstellung.

Nach Aufladung des Kondensators C8 über den Widerstand R10 ist der Rücksetzeingang R des Binärzählers IC2.1 auf L-Potential geschaltet.

Die Kombination aus den Widerständen R1 und R4 und dem Kondensator C4 dient sowohl zum verzögerten Anschalten des ersten Zählimpulses (nach dem Rücksetzimpuls) als auch zum Entprellen der rastfreien Taste T, die bekannterweise im aktiv werdenden Zustand Fehlimpulse bringt.

Wenn die Spannung am Kondensator C4 die Eingangsschwellspannung vom Inverter IC1.1 überschreitet, gibt es am Ausgang vom Inverter IC1.2 einen Sprung nach H, der über den Kondensator C6 differenziert den ersten Zählimpuls für den Binärzähler IC2.1 liefert.

Der Ausgang Q0 des Binärzählers IC2.1 nimmt dabei H-Potential an und der Transistor T3 wird leitend.

Der positive Spannungssprung wird über den Kondensator C9 differenziert an das ausserhalb der Leiterplatte angeordnete bipolare Relais Rls1 gegeben, welches nun aktiv wird und über seinen Kontakt rls1 die Sperre freigibt.

Beim nächsten kurzen Tastendruck der rastfreien Taste T nimmt durch den zweiten Zählimpuls der Ausgang Q0 vom Binärzähler IC2.1 L-Potential an. Der Transistor T4 wird leitend und durch Anlegen der entgegengesetzten Polarität des Kondensators C9 schaltet das bipolare Relais Rls1 seinen Kontakt rls1 in die Ruhelage zurück. Der Kontakt rls1 sperrt und nach Loslassen der rastfreien Taste T wird die Stromversorgung S kurzgeschlossen.

Innerhalb der Stromversorgung S dient der Widerstand RA bekannterweise zum Identifizieren des Apparates, die Kondensatoren CA und CB schliessen den Brückengleichrichter DA ... DD wechselspannungsmässig kurz.

Die Diode DE begrenzt die Betriebsspannung dieser Schaltung durch ihren Wert.

Weiterhin zeigen die Figuren 1 und 2, dass eine Abschaltautomatik A vorgesehen ist.

Die Dioden D1, D2 und D3, die Kondensatoren C1 und C3 und der Transistor T2 bringen das Relais Rls1 beim Auflegen des Handapparates in Ruhelage. Wird der Handapparat aufgelegt, so wird die Spannung an der Basis des Transistors T2 schneller negativ als am Emitter, die im Kondensator C1 gespeicherte Gleichspannung erscheint infolge des Leitendwerdens des Transistors T2 am Kollektor.

Der Binärzähler IC2.1 bekommt den Rücksetzimpuls und der Ausgang Q0 nimmt L-Potential an, das Relais Rls1 wird dadurch in Ruhelage gebracht.

Ferner ist ein Verzögerungsglied VG angeordnet. Wird die rastfreie Taste T länger als die Aufladezeit vom Kondensator C5 über den Widerstand R6 gedrückt, so nimmt durch Überschreiten der Schwellspannung des Inverters IC1.3 der Ausgang 7 L-Potential an.

War beim Tastendruck zu Beginn ein Ausschaltvorgang eingeleitet, so folgt über den Enable-Eingang E des Binärzählers IC2.1 ein weiterer Zählimpuls über den Widerstand R8, der im Zusammenhang mit der Diode D4 eine ODER-Verknüpfung bildet, welcher über den Ausgang Q0 und den Transistor T3 das bipolare Relais Rls1 nachtriggert, so dass die Stromversorgung S angeschaltet ist.

Die Diode D4 verhindert den Zählimpuls am Enable-Eingang E des Binärzählers IC2.1, wenn zu

Beginn des Tastendruckes ein Einschaltvorgang eingeleitet wurde.

Erfindungsgemäss wird dadurch bei jedem Tastendruck, der länger als die Aufladezeit des Kondensators C5 über den Widerstand R6 dauert, eine Lautstärkeeinstellung LE eingeleitet.

Zu Beginn eines jeden Tastendruckes wird der Binärzähler IC2.2 über den Kondensator C6 und den Widerstand R9 in Nullstellung gebracht.

Nach dem Rücksetzen des Binärzählers IC2.2 und nach dem Aufladen des Kondensators C5 nimmt der Ausgang 8 des NAND-Gatters IC1.4 L-Potential an.

Der Impulsgenerator IC1.5 und IC1.6 gibt nach Freigabe des Einganges von IC1.5 abhängig von der Zeitkonstante des Widerstandes R7 und des Kondensators C7 Rechteckimpulse in den Enable-Eingang E des Binärzählers IC2.2.

Am Summierungspunkt der Widerstände R11, R12, R13 und R14 erscheint eine treppenförmig ansteigende Spannung mit linearem Charakter, die durch den Kondensator C2 geglättet wird, um Knackgeräusche bei welchselnder Lautstärke zu vermeiden.

Diese ansteigende Spannung am Gate G des Regeltransistors T1 lässt den P-Kanal hochohmiger werden. Die Wechselspannung am Eingang 9 des Lauthörverstärkers V und die Lautstärke werden grösser. Durch den Widerstand R2 wird die Grundlautstärke bestimmt.

Der Widerstand RB ist als Quellwiderstand für den Regeltransistor T1 zu betrachten.

Beim achten Schritt des Binärzählers IC2.2 nimmt der Ausgang Q3 H-Potential an.

Der Binärzähler IC2.2 wird gesperrt und damit die grösste Lautstärke gekennzeichnet.

Jedes erneute Drücken der rastfreien Taste bewirkt durch das Rücksetzen des Binärzählers IC2.2 in Nullstellung die Grundlautstärke.

Die Anschlüsse ET2 und ET2A sind in die Schleife des Fernsprechapparats wie bekannt eingefügt; daraus resultiert eine Serienspeisung. HS3 und HS4 sind die Anschlüsse des Fernsprechapparats für die Hörkapsel.

**Patentansprüche**

1. Mittels einer rastfreien Taste (T) betätigbare Anordnung zum Ein- und Ausschalten und zur Lautstärkeeinstellung für einen Verstärker (V) enthaltende fernmeldetechnische Geräte wie Freisprech- oder Lauthöreinrichtungen mit einer nach Schleifenstromunterbrechung wirksam werden den Abschaltautomatik (A) für die Stromversorgung (S) des Verstärkers (V), dadurch gekennzeichnet, dass die Taste (T) mit zum einen einer Relaissteuerung (RS) für das Ein- und Ausschalten des Verstärkers (V) und zum anderen einer die Verstärkung dieses Verstärkers (V) steuernden Lautstärkeeinstelleinrichtung (LE) über ein Verzögerungsglied (VG) gekoppelt ist, das jeden Tastendruck während dessen Dauer bis zu einem ersten zeitlichen Grenzwert als Ein- oder Ausschaltbefehl für die Relaissteuerung (RS) und anschliessend bis zu einem zweiten zeitlichen Grenzwert als Steuerbefehl zu fortlaufender Erhöhung der Verstärkung ausgehend von einem Grundwert für die Lautstärkeeinstelleinrichtung (LE) wirksam werden lässt.

2. Anordnung nach Anspruch 1, dadurch gekennzeichnet, dass die Relaissteuerung (RS) einen Binärzähler (IC 2.1) aufweist, an dessen Ausgang (Q0) Transistoren (T3 und T4) in einer Gegentaktschaltung zur Stromverstärkung, ein Kondensator (C9), ein bipolares Relais (RLS1) und eine mit seinem Enable-Eingang (E) verbundene Diode (D4) angeschlossen sind und an dessen Rücksetzeingang (R) ein Kondensator (C8) und ein Widerstand (R10) und an dessen Takteingang (C) ein Kondensator (C6), ein Widerstand (R9) und Inverter (IC1.1 und IC1.2) liegen.

3. Anordnung nach Anspruch 1 oder 2, dadurch gekennzeichnet, dass die Abschaltautomatik (A) einen Transistor (T2) aufweist, dessen Basis mit einer Diode (D3) und einem Kondensator (C3), dessen Emitter mit einer Diode (D1) und einem Kondensator (C1) und dessen Kollektor mit einem Rücksetzeingang (R) eines Binärzählers (IC2.1) verbunden ist.

4. Anordnung nach einem der Ansprüche 1 bis 3, dadurch gekennzeichnet, dass das Verzögerungsglied (VG) aus einer Reihenschaltung eines Widerstandes (R6) und eines Kondensators (C5) und aus einer Reihenschaltung eines Widerstandes (R8) und eines Inverters (IC1.3) aufgebaut ist.

5. Anordnung nach einem der Ansprüche 1 bis 4, dadurch gekennzeichnet, dass die Lautstärkeverstelleinrichtung (LE) Widerstände (R2, R3) und einen Glättungskondensator (C2) sowie einen Binärzähler (IC2.2) aufweist, an dessen durch ein NAND-Gatter (IC1.4) in Abhängigkeit von der Verzögerungszeit des Verzögerungsgliedes (VG) freigebbarem Enable-Eingang (E) ein Impulsgenerator (IC1.5, IC1.6) mit Widerständen (R5 und R7) und einem Kondensator (C7), an dessen Rücksetzeingang (R) ein auch mit einem Takteingang (C) eines Binärzählers (IC2.1) verbundener Widerstand (R9), und an dessen Ausgängen (Q0, Q1, Q2, Q3) Widerstände (R11, R12, R13, R14) liegen, die am Gate (G) eines Regeltransistors (T1) einen treppenförmigen Spannungsanstieg verursachen.

**Revendications**

1. Montage commandé par une touche à rappel pour le branchement et la coupure, ainsi que le réglage du colume d'appareils de télécommunication comprenant un amplificateur (V), tels que postes d'interphonie ou avec écoute sur haut-parleur, avec un automatisme (A) de coupure de l'alimentation (S) de l'amplificateur (V), agissant après l'interruption du courant de boucle, ledit montage étant caractérisé en ce que la touche (T) est couplée d'une part avec une commande à relais (RS) de branchement et coupure de l'amplificateur (V) et d'autre part avec un dispositif de réglage du volume (LE) commandant le gain dudit amplificateur (V), par l'intermédiaire d'une ligne de retard (VG), qui fait agir chaque enfoncement de la touche, pendant sa durée jusqu'à une première valeur limite, comme instruction de branchement ou coupure de la commande à relais (RS) puis, jusqu'à une seconde valeur limite, comme instruction de commande d'accroissement continu du gain, à partir d'une valeur de base, pour le dispositif de réglage du volume (LE).

2. Montage selon revendication 1, caractérisé en ce que la commande à relais (RS) comporte un compteur binaire (IC2.1), dont la sortie (Q0) est reliée à des transistors (T3 et T4) en montage symétrique pour l'amplification de courant, un condensateur (C9), un relais bipolaire (RLS1) et une diode (D4) reliée à son entrée d'autorisation, dont l'entrée de remise à zéro (R) est relié à un condensateur (C8) et une résistance (R10), et dont l'entrée d'horloge (C) est reliée à un condensateur (C6), une résistance (R9) et des inverseurs (IC1.1 et IC1.2).

3. Montage selon une des revendications 1 ou 2, caractérisé en ce que l'automatisme de coupure (A) comporte un transistor (T2), dont la base est reliée à une diode (D3) et un condensateur (C3), dont l'émetteur est relié à une diode (D1) et un condensateur (C1), et dont le collecteur est relié à une entrée de remise à zéro (R) d'un compteur binaire (IC2.1).

4. Montage selon une quelconque des revendications 1 à 3, caractérisé en ce que la ligne de retard (VG) est constituée par le couplage en série d'une résistance (R6) et d'un condensateur (C5), et par le couplage en série d'une résistance (R8) et d'un inverseur (IC1.3).

5. Montage selon une quelconque des revendications 1 à 4, caractérisé en ce que le dispositif de réglage du volume (LE) comporte des résistances (R2, R3), un condensateur de lissage (C2) et un compteur binaire (IC2.2), dont l'entrée d'autorisation (E), qu'un opérateur NON-ET (IC1.4) autorise en fonction du retard de la ligne de retard (VG), est relié à un générateur d'impulsions (IC1.5 et IC1.6) avec des résistances (R5 et R7) et un condensateur (C7), dont l'entrée de remise à zéro (R) est reliée à une résistance (R9) également reliée à une entrée d'horloge (C) d'un compteur binaire (IC2.1), et dont les sorties (Q0, Q1, Q2, Q3) sont reliées à des résistances (R11, R12, R13, R14), qui produisent une croissance de tension en escalier sur la grille (G) d'un transistor de réglage (T1).

**Claims**

1. An arrangement which is operated by means of a non-locking key (T) for on-off switching and volume control of telecommunication devices containing an amplifier (V), such as free-speech or loud-speaking devices, including automatic disconnecting means (A) for disconnecting the power supply (S) of the amplifier (V) when the loop current is interrupted, characterized in that the key (T) is coupled, on the one hand, to a relay control (RS) for on-off switching of the amplifier (V) and, on the other hand, to a volume control means (LE) controlling the gain of this amplifier (V) via a delay circuit (VG) which causes each key depression for the duration thereof, until a first time limit has been reached, to become effective as on or off switching instruction for the relay control (RS) and subsequently, until a second time limit has been reached, to become effective as a control instruction for the continuous increase of the gain, based on a basic value for the volume control means (LE).

2. Arrangement according to claim 1, characterized in that the relay control (RS) includes a binary counter (IC2.1) to the output terminal (Q0) of which there are connected transistors (T3 and T4) in a push-pull circuit for current amplification, a capacitor (C9), a bipolar relay (RLS1), and a diode (D4) connected to the enable input (E) thereof, and to the reset input (R) of which a capacitor (C8) and a resistor (R10) are connected, and to the clock input (C) of which there are connected a capacitor (C6), a resistor (R9), and inverter circuits (IC1.1 and IC1.2).

3. Arrangement according to any of the claims 1 or 2, characterized in that the automatic disconnecting means (A) includes a transistor (T2) whose base is connected to a diode (D3) and a capacitor (C3), and whose emitter is connected to a diode (D1) and a capacitor (C1), and whose collector is connected to a reset input (R) of a binary counter (IC2.1).

4. Arrangement according to any of the claims 1 to 3, characterized in that the delay circuit (VG) is composed of a series circuit of a resistor (R6) and a capacitor (C5) and of a series circuit of a resistor (R8) and an inverter (IC1.3).

5. Arrangement according to any of the claims 1 to 4, characterized in that the volume control means (LE) includes resistors (R2, R3) and a smoothing capacitor (C2) as well as a binary counter (IC2.2) to the enable input (E) of which, which is enabled by a NAND-gate (IC1.4) in response to the delay time of the delay circuit (VG), there is connected a pulse generator (IC1.5, IC1.6) including resistors (R5 and R7) and a capacitor (C7), and to the reset input (R) of which there is connected a resistor (R9) which is also connected to a clock input (C) of a binary counter (IC2.1), and to the outputs (Q0, Q1, Q2, Q3) of which resistors (R11, R12, R13, R14) are connected which cause a staircasetype voltage increase at the gate (G) of a control transistor (T1).

*1/2*

Fig. 1

Fig. 2